# EUROPÄISCHE PATENTSCHRIFT

(11) **EP 4 257 930 B1**
(45) Veröffentlichungstag und Bekanntmachung des Hinweises auf die Patenterteilung: **21.05.2025**
(21) Anmeldenummer: 23165318.9
(22) Anmeldetag: 30.03.2023
(51) Int. Cl.: G01D 21/00, G01D 5/14, G01D 9/00, G01D 11/30, H03K 17/95, H03K 17/97

(54) **AUTOMATISCHE MESSORTERKENNUNG EINES LOGGERS**
AUTOMATIC MEASUREMENT LOCATION DETECTION OF A SENSOR DATA LOGGER
DÉTECTION AUTOMATIQUE DE L'EMPLACEMENT DE MESURE D'UN CAPTEUR ENREGISTREUR

(30) Priorität: 06.04.2022 DE 102022108279
(43) Veröffentlichungstag der Anmeldung: 11.10.2023
(73) Patentinhaber: Testo SE & Co. KGaA, 79822 Titisee-Neustadt (DE)
(72) Erfinder: Bach, Sebastian, 79874 Breitnau (DE)
(74) Vertreter: Mertzlufft-Paufler, Cornelius

(56) Entgegenhaltungen:
- WO-A1-2023/084201
- DE-A1- 102020 110 429
- US-A1- 2016 324 442

## Beschreibung

Die Erfindung betrifft einen Sensor-Kit mit einer Sensoreinheit und wenigstens einer Sensoreinheit-Halterung. Ein derartiger Sensor-Kit findet in der Praxis vielfach Anwendung.

Die Erfindung betrifft weiter ein Verfahren zur Aufnahme von Messwerten, wobei eine Sensoreinheit an einer Sensoreinheit-Halterung befestigt wird und automatisch wiederkehrend Messwerte erfasst werden. Ein solches Verfahren ist in der Praxis bekannt.

Aus der US 2016/324442 A1 ist ein loses, tragbares Empfängersystem bekannt. Lose, tragbare Empfängersysteme sind in der Lage, physiologische Informationen, beispielsweise Herzfrequenz, Temperatur oder ähnliches, über einen Träger des Systems zu erkennen, aufzuzeichnen und/oder zu übertragen.

Aus der WO 2023/084201 A1 ist eine Halterung bekannt, die so angeordnet ist, dass sie ein elektronisches Modul, ein Verfahren und ein System aufnimmt und festhält. Die Halterung kann hierbei eine Energieübertragungsschnittstelle umfassen, die so angeordnet ist, dass sie Energie an das Elektronikmodul überträgt, wenn es von der Halterung gehalten wird.

Aus der DE 10 2020 110429 A1 ist ein kontaktloses Sensoridentifikationssystem, eine Armatur für ein Sensoridentifikationssystem und ein elektrochemischer Sensor für ein Sensoridentifikationssystem bekannt.

Der Erfindung liegt die Aufgabe zugrunde, die Bedieneigenschaften von Sensor-Kits zu verbessern und die durchgeführten Messungen genauer auszugestalten. Die Aufgabe wird durch die Merkmale der unabhängigen Ansprüche gelöst. Vorteilhafte Ausgestaltungen sind in den Unteransprüchen beschrieben.

Es ist darauf hinzuweisen, dass die in den abhängigen Patentansprüchen einzeln aufgeführten Merkmale in beliebiger technologisch sinnvoller Weise miteinander kombiniert werden können und weitere Ausgestaltungen der Erfindung definieren. Darüber hinaus werden die in den Patentansprüchen angegebenen Merkmale in der Beschreibung näher präzisiert und erläutert, wobei weitere bevorzugte Ausgestaltungen der Erfindung dargestellt werden.

Zur Lösung der gestellten Aufgabe schlägt die Erfindung die Merkmale von Anspruch 1 vor. Insbesondere wird somit erfindungsgemäß bei einem Sensor-Kit der eingangs beschriebenen Art zur Lösung der genannten Aufgabe vorgeschlagen, dass an der Sensoreinheit-Halterung ein magnetisch aktiver Bereich ausgebildet ist, und dass die Sensoreinheit einen Magnetfeldsensor aufweist, mit welchem eine Relativposition des magnetisch aktiven Bereichs zur Sensoreinheit ermittelbar ist. Bevorzugt ist die Relativposition ein Messort. Besonders bevorzugt ist die Relativposition eine Position in einer Messumgebung. Somit kann die Relativposition genau und zuverlässig und automatisch bestimmt werden, und benötigt keine manuelle Eingabe eines Benutzers.

Nachfolgend werden vorteilhafte Ausgestaltungen der Erfindung beschrieben, die allein oder in Kombination mit den Merkmalen anderer Ausgestaltungen optional zusammen mit den Merkmalen nach Anspruch 1 kombiniert werden können.

Um eine Zuordnung von Messwerten und die damit verknüpfte Überprüfung der Grenzwerte sicher zu stellen, muss der Messort, beispielsweise ein Kühlschrank, eine Kühlbox oder ein Geschirrspüler, bekannt sein. Im Stand der Technik ist es so, dass in stationären Anwendungen dies bei der Inbetriebnahme manuell durch eine Eingabe eines Benutzers erfolgt. Der Messort wird somit manuell eingegeben. Dies ist allerdings sehr aufwendig und fehleranfällig und führt zu Ungenauigkeiten in der Messorterkennung.

Die vorliegende Erfindung greift hier dieses Problem auf und möchte eine Verbesserung liefern. Die Erfindung ist vor allem anwendbar bei dynamischen Applikationen mit temporärer Überwachung, wie zum Beispiel der Transport, die Anwendung in Spülmaschinen oder beim "Cook and chill"-Verfahren, wo sich der Messort sehr oft ändert und eine manuelle Einstellung des Messortes nicht mehr effizient und zuverlässig durchgeführt werden kann.

Die Erfindung sorgt dafür, dass eine automatische und damit sichere Zuordnung von Messwerten zum Messort bei wechselnden Bedingungen stattfinden kann.

Bei einer vorteilhaften Ausgestaltung kann vorgesehen sein, dass die Sensoreinheit-Halterung zu einer Aufnahme der Sensoreinheit in einer definierten Lage und/oder Orientierung eingerichtet ist. Somit kann die Sensoreinheit in die Nähe der Sensoreinheit-Halterung gebracht werden und Informationen, beispielsweise Ortsinformationen, zwischen beiden Objekten können ausgetauscht werden.

Die Sensoreinheit kann als Logger ausgeprägt sein.

Bei einer vorteilhaften Ausgestaltung kann vorgesehen sein, dass der Magnetfeldsensor als Hall-Sensor ausgebildet ist. Somit kann ein kostengünstiges und zuverlässig messendes Element bereitgestellt werden. Der Hall-Sensor kann eine Ortsinformation oder eine Positionsangabe, welche im magnetisch aktiven Bereich hinterlegt ist oder durch die Position eines Permanentmagneten vorgegeben ist, auslesen.

Der Hall-Sensor kann diskret oder integriert sein.

Bei einer vorteilhaften Ausgestaltung kann vorgesehen sein, dass der magnetisch aktive Bereich als Permanentmagnet ausgebildet ist. Somit kann der magnetisch aktive Bereich auf einfachem Wege und kostengünstig gestaltet werden.

Bevorzugt wird der Permanentmagnet auf die Sensoreinheit-Halterung geklebt, magnetisch am Gehäuse angebracht oder lösbar befestigt.

Der Permanentmagnet kann an unterschiedlichen Positionen auf die Sensoreinheit-Halterung angebracht werden. Die unterschiedliche Position des Permanentmagneten ermöglicht eine Kennung der Sensoreinheit-Halterung. Die Kennung wird mit einem Messort in Verbindung gebracht.

Bei einer erfindungsgemäßen Ausgestaltung ist vorgesehen, dass in dem magnetisch aktiven Bereich eine Ortsinformation oder eine Positionsangabe hinterlegt ist, welche durch die Sensoreinheit (2) ausgelesen werden kann. Somit kann eine Kennung zuverlässig hinterlegt werden.

Bei einer vorteilhaften Ausgestaltung kann vorgesehen sein, dass die Ortsinformation oder die Positionsangabe durch eine Positionierung des magnetisch aktiven Bereichs an der Sensoreinheit-Halterung vorgegeben ist. Somit sind zahlreiche Ortsinformationen oder Positionsangaben darstellbar und auswählbar.

Bei einer vorteilhaften Ausgestaltung kann vorgesehen sein, dass die Sensoreinheit die Ortsinformation oder die Positionsangabe in einem Datenspeicher abspeichern kann. Somit können Ortsinformation oder Positionsangaben mit anderen vorhandenen Messwerten verknüpfbar sein.

Die Ortsinformation oder die Positionsangabe ist bevorzugt ein Messort, an welchem eine bestimmte Messung eines Parameters, beispielsweise eine Strömungsrate oder eine Temperatur, stattfindet.

Bevorzugt verfügt die Sensoreinheit über einen Datenspeicher, in welchem die Ortsinformation oder die Positionsangabe abspeicherbar ist. Zusätzlich können in dem Datenspeicher Messwerte, beispielsweise eine gemessene Temperatur oder ein gemessener Druck, abspeicherbar sein.

Bei einer vorteilhaften Ausgestaltung kann vorgesehen sein, dass in dem Datenspeicher die Ortsinformation oder die Positionsangabe und Messwerte abgespeichert sind. Somit können historische Messwerte und Messorte einfach und schnell abrufbar und zuordenbar sein.

Bei einer vorteilhaften Ausgestaltung kann vorgesehen sein, dass eine weitere Sensoreinheit-Halterung zur Aufnahme der Sensoreinheit ausgebildet ist, die sich von der Sensoreinheit-Halterung in dem magnetisch aktiven Bereich unterscheidet. Somit kann eine Ortsinformation oder Positionsangabe einfach und zuverlässig im magnetisch aktiven Bereich codiert und hinterlegt sein.

Bei einer vorteilhaften Ausgestaltung kann vorgesehen sein, dass die Sensoreinheit einen von dem Magnetfeldsensor separaten Messsensor hat. Somit kann die Sensoreinheit mehrere Messwerte gleichzeitig messen.

Bei einer vorteilhaften Ausgestaltung kann vorgesehen sein, dass die Sensoreinheit über eine Eingabeeinheit und eine Anzeigeeinheit verfügt. Bevorzugt kann die Eingabeeinheit durch Knöpfe ausgeprägt sein. Die Eingabeeinheit kann auch als Touchscreen ausgeprägt sein. Bevorzugt ist die Anzeigeeinheit als Display ausgeprägt. Somit kann ein Benutzer zuverlässig und schnell Eingaben in die Sensoreinheit tätigen und gleichzeitig die Anzeige eines Messwerts im Auge behalten.

Zur Lösung der genannten Aufgabe sind erfindungsgemäß die Merkmale des auf ein Verfahren zur Aufnahme von Messwerten gerichteten nebengeordneten Anspruchs vorgesehen. Insbesondere wird zur Lösung der genannten Aufgabe somit erfindungsgemäß bei einem Verfahren der eingangs beschriebenen Art vorgeschlagen, dass während der Aufnahme eine Lage eines magnetisch aktiven Bereichs an der Sensoreinheit-Halterung detektiert wird, und dass eine zu der Lage korrespondierende Information mit den Messwerten abgespeichert wird. Somit kann eine automatische Information über den Messort in Verbindung mit einer Information über den Messwert bereitgestellt werden.

Bei einer erfindungsgemäßen Ausgestaltung ist vorgesehen, dass die Sensoreinheit zur Aufnahme weiterer Messwerte an einer weiteren Sensoreinheit-Halterung befestigt wird, deren magnetisch aktiver Bereich verschieden von demjenigen der Sensoreinheit-Halterung ausgebildet ist. Somit können unterschiedliche Messorte automatisch bereitgestellt werden.

Der Vorteil der Erfindung ist die automatische und sichere Zuordnung von Messwerten zum Messort bei wechselnden und nicht-stationären Bedingungen.

Die Erfindung wird nun anhand eines Ausführungsbeispiels näher beschrieben, ist jedoch nicht auf dieses Ausführungsbeispiel beschränkt. Weitere Ausführungsbeispiele ergeben sich durch Kombination der Merkmale einzelner oder mehrerer Schutzansprüche untereinander und/oder mit einzelnen oder mehreren Merkmalen des Ausführungsbeispiels und/oder der zuvor beschriebenen Varianten erfindungsgemäßer Vorrichtungen und Verfahren.

Es zeigt:

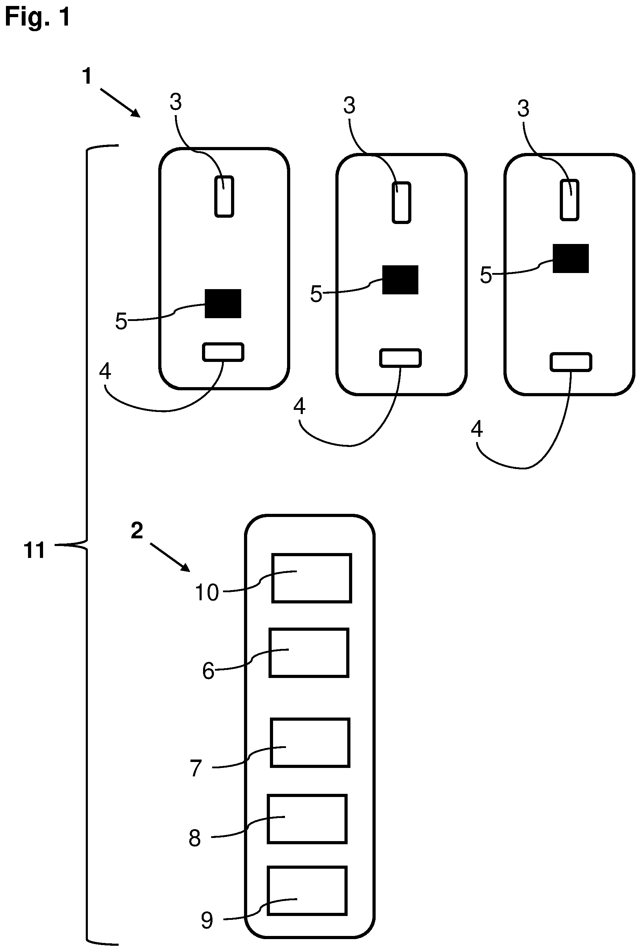

Fig. 1 eine Sensoreinheit und drei Sensoreinheit-Halterungen

Bei der nachfolgenden Beschreibung verschiedener Ausführungsbeispiele der Erfindung erhalten in ihrer Funktion übereinstimmende Elemente auch bei abweichender Gestaltung oder Formgebung übereinstimmende Bezugszahlen.

Zur besseren Übersicht sind in den Figuren nicht alle Bezugszeichen gesetzt, obwohl die Elemente sehr wohl in den Figuren vorhanden sein können. Gleiche Bezugszeichen bezeichnen jedoch funktionell und/oder konstruktiv gleiche Bauteile und Funktionseinheiten.

Fig. 1 zeigt eine Sensoreinheit 2 und drei Sensoreinheit-Halterungen 1. Der Sensor-Kit 11 umfasst eine Sensoreinheit 2 und wenigstens eine Sensoreinheit-Halterung 1.

Eine Sensoreinheit-Halterung 1 umfasst eine vertikale Befestigungsöffnung 3, eine horizontale Befestigungsöffnung 4 und einen magnetisch aktiven Bereich 5. Die Befestigungsöffnungen 3, 4 sorgen dafür, dass die Sensoreinheit-Halterung 1 an einer Wand oder einem anderen Objekt montierbar ist. Der magnetisch aktive Bereich 5 ist bevorzugt als Permanentmagnet ausgebildet, welcher auf die Sensoreinheit-Halterung 1 geklebt wird, magnetisch anhaftet oder lösbar befestigt ist.

Die Sensoreinheit-Halterung 1 kann aus einem Kunststoff bestehen. Alternativ kann die Sensoreinheit-Halterung 1 aus einem Metall bestehen.

Die Sensoreinheit 2 kann aus einem Kunststoff bestehen. Die Sensoreinheit 2 kann auch ein metallisches Material umfassen.

Die drei Sensoreinheit-Halterungen 1 unterscheiden sich dadurch, dass die Position des magnetisch aktiven Bereichs 5 unterschiedlich ausgeprägt ist. Die unterschiedlichen Positionen der magnetisch aktiven Bereiche 5 codieren spezifische und unterschiedliche Messorte.

Die Sensoreinheit 2 umfasst einen Magnetfeldsensor 6, eine Eingabeeinheit 7, einen Datenspeicher 8, einen separaten Messsensor 9 und eine Anzeigeeinheit 10. Bevorzugt ist der Magnetfeldsensor 6 als Hall-Sensor ausgeprägt. Die Eingabeeinheit 7 kann als ein oder mehrere Knöpfe ausgeprägt sein, welche die Sensoreinheit 2 beispielsweise ein- und ausschalten können. Die Eingabeeinheit 7 kann auch als TouchScreen oder Display ausgeprägt sein. Die Sensoreinheit 2 verfügt des Weiteren über einen Datenspeicher 8. Die Anzeigeeinheit 10 kann als Display ausgeprägt sein und zeigt bevorzugt einen gemessenen (aktuellen) oder historischen Messwert an.

Die Sensoreinheit-Halterung 1 ist zu einer Aufnahme der Sensoreinheit 2 in einer definierten Lage und/oder Orientierung eingerichtet.

Wenn die Sensoreinheit 2 in die Nähe der Sensoreinheit-Halterung 1 gebracht wird oder direkt eingehängt wird, kann der Magnetfeldsensor, insbesondere Hall-Sensor, die im magnetisch aktiven Bereich 5 der Sensoreinheit-Halterung 1 hinterlegte Ortsinformation oder Positionsangabe herauslesen und im Datenspeicher 8 abspeichern. Zusätzlich verfügt die Sensoreinheit 2 über einen anderen separaten Messsensor 9, mit welchem ein Parameter, wie beispielsweise eine Temperatur, ein Druck oder eine Strömungsrate, messbar sind/ist. Der Parameter wird ebenfalls im Datenspeicher 8 abgespeichert. Somit kann eine Messortinformation automatisiert und ohne Zutun eines Benutzers hinterlegt und herausgespielt werden.

Bei einem Sensor-Kit 11 mit einer Sensoreinheit 2 und wenigstens einer Sensoreinheit-Halterung 1, wobei an der Sensoreinheit-Halterung 1 ein magnetisch aktiver Bereich 5 ausgebildet ist und die Sensoreinheit 2 einen Magnetfeldsensor 6 aufweist, wird vorgeschlagen, dass eine Relativposition des magnetisch aktiven Bereichs 5 zur Sensoreinheit ermittelbar ist.

### Bezugszeichenliste

- 1: Sensoreinheit-Halterung
- 2: Sensoreinheit
- 3: vertikale Befestigungsöffnung
- 4: horizontale Befestigungsöffnung
- 5: magnetisch aktiver Bereich
- 6: Magnetfeldsensor
- 7: Eingabeeinheit
- 8: Datenspeicher
- 9: separater Messsensor
- 10: Anzeigeeinheit
- 11: Sensor-Kit

## Patentansprüche

1. Sensor-Kit (11) mit einer Sensoreinheit (2) und wenigstens einer Sensoreinheit-Halterung (1), **dadurch gekennzeichnet, dass** an der Sensoreinheit-Halterung (1) ein magnetisch aktiver Bereich (5) ausgebildet ist und dass die Sensoreinheit (2) einen Magnetfeldsensor (6) aufweist, mit welchem eine Relativposition des magnetisch aktiven Bereichs (5) zur Sensoreinheit (2) ermittelbar ist und dass in dem magnetisch aktiven Bereich (5) eine Ortsinformation oder eine Positionsangabe hinterlegt ist, welche durch die Sensoreinheit (2) ausgelesen werden kann.

2. Sensor-Kit (11) nach Anspruch 1, **dadurch gekennzeichnet, dass** die Sensoreinheit-Halterung (1) zu einer Aufnahme der Sensoreinheit (2) in einer definierten Lage und/oder Orientierung eingerichtet ist.

3. Sensor-Kit (11) nach einem der vorangehenden Ansprüche, **dadurch gekennzeichnet, dass** der Magnetfeldsensor (6) als Hall-Sensor ausgebildet ist.

4. Sensor-Kit (11) nach einem der vorangehenden Ansprüche, **dadurch gekennzeichnet, dass** der magnetisch aktive Bereich (5) als Permanentmagnet ausgebildet ist.

5. Sensor-Kit (11) nach einem der vorangehenden Ansprüche, **dadurch gekennzeichnet, dass** die Ortsinformation oder die Positionsangabe durch eine Positionierung des magnetisch aktiven Bereichs (5) an der Sensoreinheit-Halterung (1) vorgegeben ist.

6. Sensor-Kit (11) nach einem der vorangehenden Ansprüche, **dadurch gekennzeichnet, dass** die Sensoreinheit (2) die Ortsinformation oder die Positionsangabe in einem Datenspeicher (8) abspeichern kann.

7. Sensor-Kit (11) nach einem der vorangehenden Ansprüche, **dadurch gekennzeichnet, dass** in dem Datenspeicher (8) die Ortsinformation oder die Positionsangabe und Messwerte abgespeichert sind.

8. Sensor-Kit (11) nach einem der vorangehenden Ansprüche, **dadurch gekennzeichnet, dass** eine weitere Sensoreinheit-Halterung (1) zur Aufnahme der Sensoreinheit (2) ausgebildet ist, die sich von der Sensoreinheit-Halterung (1) in dem magnetisch aktiven Bereich (5) unterscheidet.

9. Sensor-Kit (11) nach einem der vorangehenden Ansprüche, **dadurch gekennzeichnet, dass** die Sensoreinheit (2) einen von dem Magnetfeldsensor (6) separaten Messsensor hat.

10. Sensor-Kit (11) nach einem der vorangehenden Ansprüche, **dadurch gekennzeichnet, dass** die Sensoreinheit (2) über eine Eingabeeinheit (7), insbesondere Knöpfe, und eine Anzeigeeinheit (10), insbesondere ein Display, verfügt.

11. Verfahren zur Aufnahme von Messwerten, wobei eine Sensoreinheit (2) eines Sensor-Kits nach einem der vorangehenden Ansprüche 1 bis 10, an einer Sensoreinheit-Halterung (1) befestigt wird und automatisch wiederkehrend Messwerte erfasst werden, **dadurch gekennzeichnet, dass** während der Aufnahme eine Lage eines magnetisch aktiven Bereichs (5) an der Sensoreinheit-Halterung (1) detektiert wird und dass eine zu der Lage korrespondierende Information mit den Messwerten abgespeichert wird und dass die Sensoreinheit (2) zur Aufnahme weiterer Messwerte an einer weiteren Sensoreinheit-Halterung (1) befestigt wird, deren magnetisch aktiver Bereich (5) verschieden von demjenigen der Sensoreinheit-Halterung (1) ausgebildet ist.

## Claims

1. Sensor kit (11) having a sensor unit (2) and at least one sensor unit holder (1), **characterized in that** a magnetically active region (5) is formed on the sensor unit holder (1) and **in that** the sensor unit (2) has a magnetic field sensor (6), with which a relative position of the magnetically active region (5) to the sensor unit (2) can be determined and **in that** location information or a position specification which can be read out by the sensor unit (2) is stored in the magnetically active region (5).

2. Sensor kit (11) according to claim 1, **characterized in that** the sensor unit holder (1) is set up to accommodate the sensor unit (2) in a defined position and/or orientation.

3. Sensor kit (11) according to one of the preceding claims, **characterized in that** the magnetic field sensor (6) is designed as a Hall sensor.

4. Sensor kit (11) according to one of the preceding claims, **characterized in that** the magnetically active region (5) is designed as a permanent magnet.

5. Sensor kit (11) according to one of the preceding claims, **characterized in that** the location information or the position specification is predetermined by a positioning of the magnetically active region (5) on the sensor unit holder (1).

6. Sensor kit (11) according to one of the preceding claims, **characterized in that** the sensor unit (2) can store the location information or the position specification in a data memory (8).

7. Sensor kit (11) according to one of the preceding claims, **characterized in that** the location information or the position specification and measured values are stored in the data memory (8).

8. Sensor kit (11) according to one of the preceding claims, **characterized in that** a further sensor unit holder (1) is designed to accommodate the sensor unit (2), which differs from the sensor unit holder (1) in the magnetically active region (5).

9. Sensor kit (11) according to one of the preceding claims, **characterized in that** the sensor unit (2) has a measuring sensor separate from the magnetic field sensor (6).

10. Sensor kit (11) according to one of the preceding claims, **characterized in that** the sensor unit (2) has an input unit (7), in particular buttons, and a display unit (10), in particular a display.

11. Method for recording measured values, wherein a sensor unit (2) of a sensor kit according to one of the preceding claims 1 to 10 is attached to a sensor unit holder (1) and measured values are recorded automatically on a recurring basis, **characterized in that** a position of a magnetically active region (5) on the sensor unit holder (1) is detected during the recording and **in that** information corresponding to the position is stored with the measured values, and **in that** the sensor unit (2), in order to record further measured values, is fastened to a further sensor unit holder (1), the magnetically active region (5) of which is designed differently from that of the sensor unit holder (1).

## Revendications

1. Kit de capteur (11) avec une unité de capteur (2) et au moins une monture d'unité de capteur (1), **caractérisé en ce qu'**une zone ayant une activité magnétique (5) est formée sur la monture d'unité de capteur (1) et **en ce que** l'unité de capteur (2) comporte un capteur de champ magnétique (6) avec lequel une position relative de la zone ayant une activité magnétique (5) vis-à-vis de l'unité de capteur (2) peut être déterminée et **en ce qu'**une information de localisation ou une indication de position pouvant être lue par l'unité de capteur (2) est stockée dans la zone ayant une activité magnétique (5).

2. Kit de capteur (11) selon la revendication 1, **caractérisé en ce que** la monture d'unité de capteur (1) est configurée de telle façon que l'unité de capteur (2) soit reçue dans une position et/ou une orientation définie.

3. Kit de capteur (11) selon l'une des revendications précédentes, **caractérisé en ce que** le capteur de champ magnétique (6) est un capteur à effet Hall.

4. Kit de capteur (11) selon l'une des revendications précédentes, **caractérisé en ce que** la zone ayant une activité magnétique (5) est conformée comme un aimant permanent.

5. Kit de capteur (11) selon l'une des revendications précédentes, **caractérisé en ce que** l'information de localisation ou l'indication de position est prédéterminée par le positionnement de la zone ayant une activité magnétique (5) sur la monture d'unité de capteur (1).

6. Kit de capteur (11) selon l'une des revendications précédentes, **caractérisé en ce que** l'unité de capteur (2) peut stocker l'information de localisation ou l'indication de position dans une mémoire de données (8).

7. Kit de capteur (11) selon l'une des revendications précédentes, **caractérisé en ce que** l'information de localisation ou l'indication de position et des valeurs de mesure sont stockées dans la mémoire de données (8).

8. Kit de capteur (11) selon l'une des revendications précédentes, **caractérisé en ce qu'**une autre monture d'unité de capteur (1), qui diffère de la monture d'unité de capteur (1) dans la zone ayant une activité magnétique (5), est formée pour recevoir l'unité de capteur (2).

9. Kit de capteur (11) selon l'une des revendications précédentes, **caractérisé en ce que** l'unité de capteur (2) possède un capteur de mesure séparé du capteur de champ magnétique (6).

10. Kit de capteur (11) selon l'une des revendications précédentes, **caractérisé en ce que** l'unité de capteur (2) dispose d'une unité de saisie (7), en particulier de boutons, et d'une unité d'indication (10), en particulier d'un affichage.

11. Procédé pour l'acquisition de valeurs de mesure, dans lequel l'unité de capteur (2) d'un kit de capteur selon l'une des revendications précédentes 1 à 10 est fixée à une monture d'unité de capteur (1) et des valeurs de mesure récurrentes sont captées automatiquement, **caractérisé en ce qu'**une position d'une zone ayant une activité magnétique (5) sur la monture d'unité de capteur (1) est détectée pendant l'acquisition et **en ce qu'**une information correspondant à la position est mémorisée avec les valeurs de mesure et **en ce que**, pour l'acquisition d'autres valeurs de mesure, l'unité de capteur (2) est fixée à une autre monture d'unité de capteur (1) dont la zone ayant une activité magnétique (5) a une conformation différente de celle de la monture d'unité de capteur (1).
